# EUROPÄISCHE PATENTSCHRIFT

(11) **EP 0 685 782 B1**
(45) Veröffentlichungstag und Bekanntmachung des Hinweises auf die Patenterteilung: **17.10.2001**
(21) Anmeldenummer: 95108202.3
(22) Anmeldetag: 30.05.1995
(51) Int. Cl.: G05F 1/563, G05F 3/26

(54) **Spannungsregler**
Voltage regulator
Regulateur de tension

(30) Priorität: 31.05.1994 DE 4418988; 03.09.1994 DE 4431466
(43) Veröffentlichungstag der Anmeldung: 06.12.1995
(73) Patentinhaber: Micronas GmbH, 79108 Freiburg (DE)
(72) Erfinder: Theus, Ulrich, Dr.-Ing., D-79194 Gundelfingen (DE); Motz, Mario, Dipl.-Ing., D-79346 Endingen (DE)

(56) Entgegenhaltungen:
- EP-A- 0 460 263
- DE-C- 4 242 989

## Beschreibung

Die Erfindung betrifft einen Spannungsregler mit einem ersten p-Kanal-MOS-Transistor und einem dazu parallelgeschalteten ersten n-Kanal-MOS-Transistor, deren Gate-Anschlüsse mit einem Ausgang eines Regelverstärkers gekoppelt sind, wobei der Source-Anschluß des ersten p-Kanal-Transistors mit einem ersten und der Source-Anschluß des ersten n-Kanal-Transistors mit einem zweiten Festpunkt verbunden ist, und mit einer Schalteinrichtung, die den Strom des ersten p-Kanal-Transistors und den Strom des ersten n-Kanal-Transistors zur Differenzbildung in einen mit einer Ausgangsleitung verbundenen Knotenpunkt koppelt.

Ein solcher Spannungsregler ist aus DE 42 42 989 bekannt (ITT case C-DIT-1453). Er wird für zu regelnde IC-interne Referenz-bzw. Versorgungsspannungen, z.B. für die Versorgungsspannung und den Betrieb von Hallelementen, verwendet. Er hat den wesentlichen Vorteil, daß keine externen Bauelemente erforderlich sind, und somit die Anzahl der Anschlußbeine eines Chips und das Einfangen äußerer elektromagnetischer Strahlung verringert werden kann. Dies ist bei der Verwendung des Spannungsreglers in der Automobiltechnik wesentlich. Durch die beschriebene Anordnung des ersten p-Kanal-Transistors und des ersten n-Kanal-Transistors wird eine lineare Übertragungskennlinie der Ausgangsstufe des Spannungsreglers erzielt. Diese kommt durch die Überlagerung der Ausgangsströme der beiden Transistoren mit quadratischen Kennlinien in dem Knotenpunkt zustande. Durch die lineare Übertragungskennlinie wird vermieden, daß bei hochfrequenten Störeinstrahlungen die geregelte Spannung des ICs moduliert wird. Dies ist insbesondere wichtig, wenn HF-Störstrahlung mit großen Amplituden auftreten kann, wie dies z.B. beim Einsatz in der Automobiltechnik der Fall ist. Der Treibertransistor für die Ausgangsleitung ist ein als Source-Stufe ausgebildeter n-Kanal-Transistor.

Ein Nachteil des bekannten Spannungsreglers besteht darin, daß der dynamische Ausgangswiderstand, insbesondere bei hohen Frequenzen groß ist. Dadurch wird die Unterdrückung des Einflusses von HF-Störstrahlung begrenzt.

Der Erfindung liegt die Aufgabe zugrunde, einen Spannungsregler zu schaffen, bei dem HF-Störeinflüsse besser unterdrückt werden.

Diese Aufgabe wird durch einen gattungsgemäßen Spannungsregler gelöst, bei dem der erste Festpunkt der Knotenpunkt ist. Die Festpunkte haben ein bezüglich der geregelten Ausgangsspannung festes Potential.

Bei dem erfindungsgemäßen Spannungsregler ist der Source-Anschluß des ersten p-Kanal-Transistors mit der Ausgangsleitung gekoppelt. Dieser p-Kanal-Transistor ist dabei als Sourcefolgerstufe geschaltet. Er hat über den gesamten Frequenzbereich einen relativ niedrigen dynamischen Ausgangswiderstand, auch ohne Rückkopplung. Der dynamische Ausgangswiderstand ohne Rückkopplung ist über den gesamten Frequenzbereich insbesonders niedriger als der mit einem als Sourcestufe gaschalteten n-Kanal-Transitor gemäß dem oben erwähnten Stand der Technik erzielte Ausgangswiderstand. Als Folge wird eine HF-Störstrahlung bei dem erfindungsgemäßen Spannungsregler besser unterdrückt und das EMV(Elektromagnetische Verträglichkeit)-Verhalten des Spannungsreglers verbessert. Durch Schaltung des p-Kanal-Transistors als Sourcefolgestufe wird eine unmittelbare Wirkung der ansteuernden Spannung der Endstufe (von dem Ausgang des Regelverstärker bzw. der Vorstufe kommende Spannung) auf die Ausgangsspannung des Spannungsreglers erreicht, auch ohne Rückkopplung. Die Kopplung des Source-Anschlusses des p-Kanal-Transistors mit der Ausgangsleitung hat ferner den Vorteil, daß die Steuerspannung am Gate ein niedrigeres Potential aufweist als bei einer vergleichbaren Source-Folgerschaltung eines n-Kanal-Enhancement-Transistors. Damit kann der Regelverstärker auch bei einer niedrigen Betriebsspannung ohne Beeinträchtigung den p-Kanal-Transistor ansteuern. Für die Transistoren können MOS-Enhancement-Transistoren verwendet werden.

Vorteilhafterweise ist der erste p-Kanal-Transistor der Treibertransistor für die Ausgangsleitung. In diesem Fall erfolgt die Unterdrückung der Störstrahlung besonders wirkungsvoll.

Gemäß einem vorteilhaften Ausführungsbeispiel der Erfindung kann die Schalteinrichtung einen p-Kanal-Stromspiegel umfassen, desen Eingang mit dem Drain-Anschluß des ersten n-Kanal-Transistors gekoppelt ist und dessen erster Ausgang mit dem ersten Festpunkt verbunden ist. Der p-Kanal-Stromspiegel überlagert die Ausgangsströme des ersten p-Kanal-Transistors und des ersten n-Kanal-Transistors mit entgegengesetzten quadratischen Kennlinien auf einfache Weise in dem Knotenpunkt. Es kann in dem Stromspiegel eine Steilheitsanpassung des ersten n-Kanal-Transistors an den ersten p-Kanal-Transistor erfolgen. Die Source-Anschlüsse des p-Kanal-Stromspiegels können mit einer ersten Versorgungsleitung verbunden sein. Auf diese Versorgungsleitung kann eine postive Betriebsspannung VDD gelegt werden. Ferner kann ein zweiter Ausgang des p-Kanal-Stromspiegels mit einem Eingang eines ersten n-Kanal-Stromspiegels gekoppelt sein, dessen Ausgang mit dem zweiten Festpunkt gekoppelt ist. Hierdurch wird eine zuverlässige Stabilisierung des zweiten Festpunktes und damit des Source-Anschlusses des ersten n-Kanal-Transistors und des durch diesen fließenden Stromes bewirkt.

Die Source-Anschlüsse des ersten n-Kanal-Stromspiegels und der Drain-Anschluß des ersten p-Kanal-Transistors können an einer zweiten Versorgungsleitung liegen, die negativ gegenüber der ersten Versorgungsleitung ist. Für die zweite Versorgungsleitung kann das Massepotential gewählt werden. Hierdurch wird eine gute Stabilisierung dieser Komponenten und eine Unterdrückung der Einflüsse von Störstrahlung bewirkt.

Es ist vorteilhaft, wenn zwischen der Ausgangsleitung und der zweiten Versorgungsleitung ein zweiter p-Kanal-Transistor, ein zweiter n-Kanal-Transistor und eine Quelle in Reihe geschaltet sind, wobei ein Anschluß der Stromquelle mit der zweiten Versorgungsleitung und der andere Anschluß mit dem zweiten Festpunkt verbunden ist. Liegt die zweite Versorgungsleitung auf Masse, so ist die Stromquelle geerdet und stellt einen von der Betriebsspannung unabhängigen Arbeitsstrom für den zweiten p-Kanal-Transistor und den zweiten n-Kanal-Transistor zur Verfügung. Über letztere wird dann eine von der Betriebsspannung unabhängige Arbeitsspannung eingestellt, in welche die Steilheit der zweiten Transistoren eingeht. Es ist vorteilhaft, wenn die Steilheit dieser beiden Transistoren der Steilheit des ersten p- und des ersten n-Kanal-Transistors angepaßt ist, wobei der Strom der Stromquelle in die Steilheitsbetrachtung einzubeziehen ist. Aufgrund dieser Anordnung wird ein Referenzspannungswert an dem zweiten Festpunkt und damit an dem Source-Anschluß des ersten n-Kanal-Transistors zur Verfügung gestellt. Aufgrund einer Kompensationsschaltung die den ersten n-Kanal-Stromspiegel enthält, wird der Innenwiderstand am 2. Festpunkt erniedrigt, so daß die Stabilität der dort anliegenden Referenzspannung im Betrieb voll gewährleistet ist.

Es kann eine erste Kapazität zur Arbeitspunktstabilisierung bei hohen Frequenzen parallel zu dem zweiten p-Kanal-Transistor und dem zweiten n-Kanal-Transistor geschaltet sein. Eine zweite Kapazität kann zwischen die Ausgangsleitung und ein Festpotential, insbesondere das Massepotential, geschaltet sein. Diese dient zum Abblocken der Versorgungsspannung des IC gegen Masse und stellt einen Strompuffer für Störspannungsspitzen dar. Hierdurch wird die Auswirkung der Änderung der Betriebsspannung, z.B. auf die Ausgangsspannung insbesondere bei sehr hohen Frequenzen weiter verbessert. Die erfindungsgemäße Anordnung der zweiten Kapazität ist besonders aufgrund der Anordnung des ersten p-Kanal-Transistors als Source-Folge-Stufe möglich, da bei einer vergleichbaren Source-Schaltung störende Schwingungen auftreten könnten. Es ist besonders vorteilhaft, wenn eine dritte Kapazität als Kompensationskapazität zwischen dem Ausgang des Regelverstärkers und der zweiten Versorgungsleitung geschaltet ist. Diese dient zur Frequenzkompensation des Spannungsreglers. Sie verbessert das dynamische Verhalten des Spannungsreglers bei mittleren und hohen Frequenzen, da sie bewirkt, daß das Gate des ersten p-Kanal-Transitors konstant gehalten wird.

Gemäß einer vorteilhaften Weiterbildung der Erfindung kann eine Detektorschaltung vorgesehen sein, die einen Unterspannungsbereich der Versorgungsspannung erkennt und in dem Unterspannungsbereich das Ausgangssignal des Regelverstärkers in eine vorgegebene Richtung ändert. Aufgrund dieser Detektorschaltung funktioniert der Spannungsregler auch dann noch zuverlässig, wenn eine relativ niedrige Versorgungsspannung an der ersten Versorgungsleitung anliegt. Dies kann beim Absinken einer Batteriespannung erforderlich sein. Stellt die Detektorschaltung fest, daß die Betriebsspannung, z.B. VDD in den Unterspannungsbereich abgesunken ist, so ändert sie das Ausgangssignal des Regelverstärkers in eine vorgegebene Richtung. In dem Fall einer positiven Betriebsspannung an der ersten Versorgungsleitung und der Masse an der zweiten Versorgungsleitung ist die vorgegebene Richtung so gewählt, daß der erste Festpunkt und damit der mit der Ausgangsleitung verbundene Knotenpunkt auf ein niedrigeres Potential im Vergleich zu seinem eigentlichen Regelwert gezogen wird. Somit ist auch noch eine zuverlässige Regelung des Potential des Knotenpunktes bei einer niedrigeren Betriebsspannung möglich.

Die Detektorschaltung kann einen dritten p-Kanal-Transistor umfassen, dessen Gate-Anschluß mit den Gate-Anschlüssen des p-Kanal-Stromspiegels zusammengeschaltet ist, dessen Source-Anschluß mit dem ersten Ausgang des p-Kanal-Stromspiegels gekoppelt ist, und dessen Drain-Anschluß mit dem Ausgang des Regelverstärkers gekoppelt ist. Wenn die Versorgungsspannung in den Unterspannungsbereich gelangt, wird der dritte p-Kanal-Transistor leitend und zieht das Potential des Ausgangs des Regelverstärkers zur zweiten Versorgungsleitung. Letzteres kann auf einfache Weise durch einen zweiten n-Kanal-Stromspiegel der Detektorschaltung erreicht werden, dessen Eingang mit dem Drain-Anschluß des dritten p-Kanal-Transistors gekoppelt ist und dessen Ausgang mit dem Ausgang des Regelverstärkers gekoppelt ist. Günstigerweise sind die Source-Anschlüsse des zweiten n-Kanal-Stromspiegels mit der zweiten Versorgungsleitung verbunden. Ist die zweite Versorgungsleitung die Masse, so wird auch hier für eine weitere Spannungs- stabilisierung gesorgt.

Es ist vorteilhaft, wenn in wenigstens einem Querstromzweig wenigstens eine Kaskodenstufe vorgesehen ist. Über diese kann in dem entsprechenden Querstromzweig eine Entkopplung von der Versorgungsspannung vorgenommen werden.

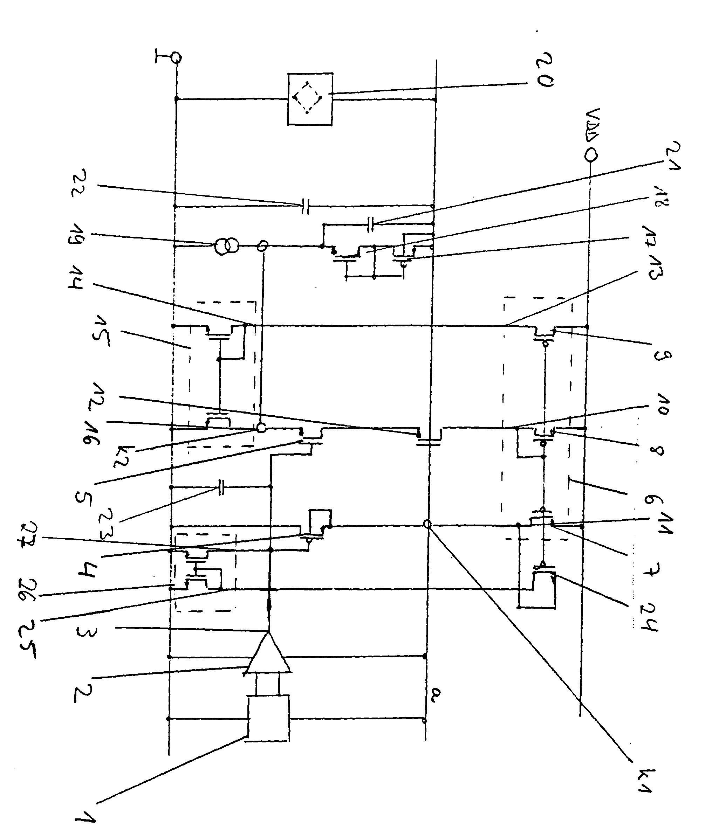

Im folgenden wird die Erfindung anhand der Figur näher beschrieben.

Die Figur zeigt ein Ausführungsbeispiel des erfindungsgemäßen Spannungsreglers.

Der in der Figur gezeigte Spannungsregler enthält eine Referenzspannungsquelle 1 und einen Vorverstärker 2, die eine Vorstufe bilden. Der Ausgang 3 des Regelverstärkers 2 ist mit den Gate-Anschlüssen eines ersten p-Kanal-Transistors 4 und eines n-Kanal-Transistors 5 verbunden. Diese Transistoren sind MOS-Enhancement Transistoren. Der erste p-Kanal-Transistor 4 ist der Treibertransistor für die Ausgangsleitung a. Sein Source-Anschluß ist mit einem auf festem Potential liegenden Knotenpunkt k1 der Ausgangsleitung verbunden. Der Source-Anschluß des ersten n-Kanal-Transistors 5 ist mit einem zweiten auf festem Potential liegenden Festpunkt k2.

Es ist ein p-Stromspiegel 6 vorgesehen, welcher drei weitere p-Kanal-MOS-Enhancement-Transistoren 7, 8, 9 umfaßt. Der Eingang 10 des p-Kanal-Stromspiegels 6 ist mit dem Drain-Anschluß des ersten n-Kanal-Transistors 5 gekoppelt. Ein erster Ausgang 11 des p-Kanal-Stromspiegels 6 ist mit dem Knotenpunkt k1 verbunden. Der Stromspiegel 6 spiegelt den Strom des ersten n-Kanal-Transistors 5 auf den Knotenpunkt k1. In dem Knotenpunkt k1 findet eine Differenzbildung des Stromes des ersten n-Kanal-Transistors 5 und des Stromes des ersten p-Kanal-Transistors 4 statt. Die beiden Transistoren 4, 5 haben eine quadratische Strom-Spannungs-Kennlinie. Durch die Differenzbildung dieser Kennlinien in dem Knotenpunkt k1 wird eine lineare Übertragungskennlinie des ersten Spannungsreglers erzielt. Zwischen den ersten n-Kanal-Transistor 5 und den Eingang 10 des p-Kanal-Stromspiegels 6 ist ein Kaskodenverstärker 12 geschaltet, welcher zur Entkopplung von der Versorgungsspannung VDD dient. Die Source-Anschlüsse des p-Kanal-Stromspiegels 6 sind mit der VDD-Versorgungsleitung verbunden.

Ein zweiter Ausgang 13 des p-Kanal-Stromspiegels 6 ist mit einem Eingang 14 eines ersten n-Kanal-Stromspiegels 15 verbunden. Der Ausgang 16 des ersten n-Kanal-Stromspiegels 15 ist mit dem zweiten Festpunkt k2 verbunden. Die Source-Anschlüsse des ersten n-Kanal-Stromspiegels 15 und der Drainanschluß des ersten p-Kanal-Transistors 4 liegen an der Masseleitung.

Zwischen der Ausgangleitung a und der Masseleitung liegen ein zweiter p-Kanal-Transistor 17, ein zweiter n-Kanal-Transistor 18 und eine Stromquelle 19, die in Reihe geschaltet sind. Die Stromquelle 19 ist mit der Masse und dem zweiten Festpunkt k2 verbunden. Die geerdete Stromquelle stellt einen von der Betriebsspannung unabhängigen Arbeitsstrom für die Reihenschaltung des zweiten p-Kanal-Transistors 17 und des zweiten n-Kanal-Transistors 18 zur Verfügung. Über letztere wird eine Arbeitsspannung eingestellt. Die Transistoren 17, 18 haben hier gleiche Steilheit. Ohne eine Aussteuerung an dem Knotenpunkt k1 stellen sich in dem ersten p-Kanal-Transistor 4 und in dem ersten n-Kanal-Transistor 5 Arbeitsströme ein, die durch das Weitenverhältnis des zweiten p-Kanal-Transistors 17 und des zweiten n-Kanal-Transistors 18 bestimmt sind. Die Stabilisierung des Knotenpunktes k1 bei einer Belastung durch einen Verbraucher 20, z.B. ein Hallelement, erfolgt durch eine Stromspiegelung an dem ersten n-Kanal-Stromspiegel 15 und an dem p-Kanal-Stromspiegel 6. Eine erste Kapazität 21 ist in Reihe mit dem zweiten p-Kanal-Transistor 17 und dem zweiten n-Kanal-Transistor 18 geschaltet. Die Kapazität 21 dient zur Stabilisierung des Knotenpunktes k1 bei hohen Frequenzen. Eine zweite Kapazität 22 ist zwischen die Ausgangsleitung a und das Massepotential geschaltet. Sie dient zum Abblocken von Störspannungsspitzen, insbesondere bei hohen Frequenzen. Zwischen den Ausgang 3 des Regelverstärkers 2 und die Masse ist eine dritte Kapazität 23 geschaltet. Sie dient zur Verhinderung von Schwingungen.

Ein dritter p-Kanal-Transistor 24 ist derart angeordnet, daß sein Gate-Anschluß mit den Gate-Anschlüssen des p-Kanal-Stromspiegels 6 zusammengeschaltet ist, sein Source-Anschluß mit dem ersten Ausgang 11 des p-Kanal-Stromspiegels 6 verbunden ist, und sein Drain-Anschluß mit dem Eingang 25 eines zweiten n-Kanal-Stromspiegels 26 verbunden ist. Der Ausgang 27 des zweiten n-Kanal-Stromspiegels 26 ist mit dem Ausgang 3 des Regelverstärkers 2 verbunden. Die Source-Anschlüsse des zweiten n-Kanal-Stromspiegels 26 sind mit der Masseleitung verbunden.

Wenn die Versorgungsspannung VDD abnimmt, geht der Transistor 7 des p-Kanal-Stromspiegels 6 aus seinem Sättigungsbereich. In diesem Fall liegt ein Unterspannungsbereich der Versorgungsspannung VDD vor. In Folge davon ändert sich das Potential an dem Source-Anschluß des dritten p-Kanal-Transistors 24. Dieser ist so ausgelegt, daß er bei einem bestimmten Unterspannungsbereich leitend wird. Der Strom des dritten p-Kanal-Transistors 24 wird von dem zweiten n-Kanal-Stromspiegel 26 gespiegelt und zieht das Potential des Festpunktes k1 nach unten. Damit liegt ein niedrigeres Potential an der Ausgangsleitung a an, welches auch bei einer niedrigeren Betriebsspannung VDD konstant geregelt werden kann.

Die Vorstufe, insbesondere die Referenzspannungsquelle 1 und der Regelverstärker 2, sowie die die Endstufe des Spannungsreglers bildenden, dem Ausgang 3 nachgeschalteten Elemente des Spannungsreglers sind zwischen die Ausgangsleitung a des Spannungsreglers und die Masse geschaltet, so daß von vornherein eine hohe Unterdrückung der Betriebsspannung vorliegt, was wiederum dazu führt, daß Störimpulse aufgrund von äußeren Einstrahlungen oder leitungsgebundene Störimpulse unterdrückt werden. Somit werden alle Arbeitsströme zwischen dem Festpunkt k1 und der Masse mit großer Unterdrückung der Betriebsspannung abgeleitet. Die in der Figur nicht näher dargestellte Vorstufe, die die Referenzspannungsquelle 1 und den Regelverstärker 2 umfaßt, kann z.B. eine Dreifach-Bandgap-Schaltung mit ca. 3 x 1,25 V = 3,75 V enthalten. Damit weist die Konstantspannung auf der Ausgangsleitung a im einfachsten Fall ebenfalls 3,75 V auf. Die Vorstufe kann aber auch über andere Rückkopplungsnetzwerke und Steuerspannungen geschaltet sein. Die Vorstufe ist vorzugsweise mit Kaskoden versehen, so daß hohe Leerlaufverstärkungen der offenen Schleife aus Vorstufe und Endstufe erreicht werden können. Hierdurch wird die Betriebsspannungsunterdrückung bei niedrigeren Frequenzen erreicht.

## Patentansprüche

1. Spannungsregler mit einem ersten p-Kanal-Transistor (4) und einem dazu parallelgeschalteten ersten n-Kanal-Transistor (5), deren Gate-Anschlüsse mit einem Ausgang eines Regelverstärkers (2) gekoppelt sind, wobei der Source-Anschluß des ersten p-Kanal-Transistors (4) mit einem ersten und der Source-Anschluß des ersten n-Kanal-Transitsors (5) mit einem zweiten auf festem Potential liegenden Festpunkt (k1, k2) verbunden ist und mit einer Schalteinrichtung, die den Strom des ersten p-Kanal-Transistors (4) und den Strom des ersten n-Kanal-Transistors (5) zur Differenzbildung in einen mit einer Ausgangsleitung verbundenen Knotenpunkt koppelt, **dadurch gekennzeichnet, daß** der erste Festpunkt (k1) der Knotenpunkt ist.

2. Spannungsregler nach Anspruch 1, **dadurch gekennzeichnet, daß** der erste p-Kanal-Transistor (4) der Treibertransistor für die Ausgangsleitung (a) ist.

3. Spannungsregler nach Anspruch 1 oder 2, **dadurch gekennzeichnet, daß** die Schalteinrichtung einen p-Kanal-Stromspiegel (6) umfaßt, dessen Eingang (10) mit dem Drain-Anschluß des ersten n-Kanal-Transistors (5) gekoppelt ist und dessen erster Ausgang (11) mit dem ersten Festpunkt (k1) verbunden ist.

4. Spannungsregler nach einem der vorangehenden Patentansprüche, **dadurch gekennzeichnet, daß** die Source-Anschlüsse des p-Kanal-Stromspiegels (6) mit einer ersten Versorgungsleitung (VDD) verbunden sind.

5. Spannungsregler nach einem der vorangehenden Patentansprüche, **dadurch gekennzeichnet, daß** ein zweiter Ausgang (13) des p-Kanal-Stromspiegels (6) mit einem Eingang (14) eines ersten n-Kanal-Stromspiegels (15) gekoppelt ist, dessen Ausgang (16) mit dem zweiten Festpunkt (k2) gekoppelt ist.

6. Spannungsregler nach einem der vorangehenden Patentansprüche, **dadurch gekennzeichnet, daß** die Source-Anschlüsse des ersten n-Kanal-Stromspiegels (15) und der Drain-Anschluß des ersten p-Kanal-Transistors (4) an einer zweiten Versorgungsleitung liegen, die negativ gegenüber der ersten Versorgungsleitung (VDD) ist.

7. Spannungsregler nach einem der vorangehenden Patentansprüche, **dadurch gekennzeichnet, daß** zwischen der Ausgangsleitung (a) und der zweiten Versorgungsleitung ein zweiter p-Kanal-Transistor (17), ein zweiter n-Kanal-Transistor (18) und eine Stromquelle (19) in Reihe geschaltet sind, wobei ein Anschluß der Stromquelle (19) mit der zweiten Versorgungsleitung und der andere Anschluß mit dem zweiten Festpunkt (k2) verbunden ist.

8. Spannungsregler nach einem der vorangehenden Ansprüche, **dadurch gekennzeichnet, daß** eine erste Kapazität (21) parallel zu den zweiten Transistoren (17, 18) geschaltet ist.

9. Spannungsregler nach einem der vorangehenden Patentansprüche, **dadurch gekennzeichnet, daß** eine zweite Kapazität (22) zwischen die Ausgangsleitung und ein Festpotential, insbesondere das Massepotential, geschaltet ist.

10. Spannungsregler nach einem der vorangehenden Patentansprüche, **dadurch gekennzeichnet, daß** eine dritte Kapazität (23) zwischen dem Ausgang (3) des Regelverstärkers (2) und die zweite Versorgungsleitung geschaltet ist.

11. Spannungsregler nach einem der vorangehenden Patentansprüche, **gekennzeichnet durch** eine Detektorschaltung, die einen Unterspannungsbereich der Versorgungsspannung (VDD) erkennt und in dem Unterspannungsbereich das Ausgangssignal des Regelverstärkers (2) in eine vorgegebene Richtung ändert.

12. Spannungsregler nach einem der vorangehenden Patentansprüche, **dadurch gekennzeichnet, daß** die Detektorschaltung einen dritten p-Kanal-Transistor (24) umfaßt, dessen Gate-Anschluß mit den Gate-Anschlüssen des p-Kanal-Stromspiegels (6) zusammengeschaltet ist, dessen Source-Anschluß mit dem ersten Ausgang (11) des p-Kanal-Stromspiegels (6) gekoppelt ist, und dessen Drain-Anschluß mit dem Ausgang (3) des Regelverstärkers (2) gekoppelt ist.

13. Spannungsregler nach einem der vorangehenden Patentansprüche, **dadurch gekennzeichnet, daß** die Detektorschaltung einen zweiten n-Kanal-Stromspiegel (26) umfaßt, dessen Eingang (25) mit dem Drain-Anschluß des dritten p-Kanal-Transistors (24) gekoppelt ist, und dessen Ausgang (26) mit dem Ausgang (3) des Regelverstärkers (2) gekoppelt ist.

14. Spannungsregler nach einem der vorangehenden Patentansprüche, **dadurch gekennzeichnet, daß** die Source-Anschlüsse des zweiten n-Kanal-Stromspiegels (26) mit der zweiten Versorgungsleitung verbunden sind.

15. Spannungsregler nach einem der vorangehenden Patentansprüche, **dadurch gekennzeichnet, daß** in wenigstens einem Querstromzweig mindestens eine Kaskodenstufe (12) vorgesehen ist.

## Claims

1. A voltage regulator comprising a first p-channel transistor (4) and a first n-channel transistor (5) connected in parallel therewith which have their gate terminals coupled to an output of an error amplifier (2), with the source terminal of the first p-channel transistor (4) connected to a first fixed-potential point (k1), and the source terminal of the first n-channel transistor (4) connected to a second fixed-potential point (k2), and a switching device which couples the current of the first p-channel transistor (4) and the current of the first n-channel transistor (5) into a node connected with an output line for obtaining the difference of the two currents, **characterized in that** the first fixed-potential point (k1) is the node.

2. A voltage regulator as claimed in claim 1, **characterized in that** the first p-channel transistor (4) is the driver transistor for the output line (a).

3. A voltage regulator as claimed in claim 1 or 2, **characterized in that** the switching device comprises a p-channel current mirror (6) having its input (10) coupled to the drain terminal of the first n-channel transistor (5) and having its first output (11) connected to the first fixed-potential point (k1).

4. A voltage regulator as claimed in any one of the preceding claims, **characterized in that** the source terminals of the p-channel current mirror (6) are connected to a first supply line (VDD).

5. A voltage regulator as claimed in any one of the preceding claims, **characterized in that** a second output (13) of the p-channel current mirror (6) is coupled to an input (14) of a first n-channel current mirror (15) having its output (16) coupled to the second fixed-potential point (k2).

6. A voltage regulator as claimed in any one of the preceding claims, **characterized in that** the source terminals of the first n-channel current mirror (15) and the drain terminal of the first p-channel transistor (4) are connected to a second supply line which is negative with respect to the first supply line (VDD).

7. A voltage regulator as claimed in any one of the preceding claims, **characterized in that** a second p-channel transistor (17), a second n-channel transistor (18), and a current source (19) are connected in series between the output line (a) and the second supply line, with one terminal of the current source (19) connected to the second supply line, and the other terminal connected to the second fixed-potential point (k2).

8. A voltage regulator as claimed in any one of the preceding claims, **characterized in that** a first capacitor (21) is connected in parallel with the second transistors (17, 18).

9. A voltage regulator as claimed in any one of the preceding claims, **characterized in that** a second capacitor (22) is connected between the output line and a fixed potential, particularly ground potential.

10. A voltage regulator as claimed in any one of the preceding claims, **characterized in that** a third capacitor (23) is connected between the output (3) of the error amplifier (2) and the second supply line.

11. A voltage regulator as claimed in any one of the preceding claims, **characterized by** a detector circuit which senses when the supply voltage (VDD) is in an undervoltage range and, if that is the case, changes the output of the error amplifier (2) in a predetermined direction.

12. A voltage regulator as claimed in any one of the preceding claims, **characterized in that** the detector circuit comprises a third p-channel transistor (24) having its gate terminal connected to the gate terminals of the p-channel current mirror (6) and having its source and drain terminals coupled to the first output (11) of the p-channel current mirror (6) and to the output (3) of the error amplifier (2), respectively.

13. A voltage regulator as claimed in any one of the preceding claims, **characterized in that** the detector circuit comprises a second n-channel current mirror (26), whose input (25) is coupled to the drain terminal of the third p-channel transistor (24) and whose output (27) is coupled to the output (3) of the error amplifier (2).

14. A voltage regulator as claimed in any one of the preceding claims, **characterized in that** the source terminals of the second n-channel current mirror (26) are connected to the second supply line.

15. A voltage regulator as claimed in any one of the preceding claims, **characterized in that** at least one cascode stage (12) is provided in at least one shunt arm.

## Revendications

1. Régulateur de tension comportant un premier transistor (4) à canal p et un premier transistor (5) à canal n qui est branché en parallèle, dans lequel les connexions de porte de ces deux transistors sont couplées à une sortie d'un amplificateur de régulation (2), la connexion de source du premier transistor (4) à canal p est reliée à un premier point fixe (k1) soumis à un potentiel fixe et la connexion de source du premier transistor (5) à canal n est reliée à un deuxième point fixe (k2) soumis à un potentiel fixe et comportant un dispositif de commutation qui couple le courant du premier transistor (4) à canal p et le courant du premier transistor (5) à canal n pour former la différence dans un point nodal relié à une ligne de sortie, **caractérisé en ce que** le premier point fixe (k1) constitue le point nodal.

2. Régulateur de tension selon la revendication 1, **caractérisé en ce que** le premier transistor (4) à canal p est le transistor d'attaque pour la ligne de sortie (a).

3. Régulateur de tension selon la revendication 1 ou 2, **caractérisé en ce que** le dispositif de commutation comprend un miroir de courant (6) à canal p dont l'entrée (10) est couplée avec la connexion de drain du premier transistor (5) à canal n et dont la première sortie (11) est reliée au premier point fixe (k1).

4. Régulateur de tension selon l'une quelconque des revendications précédentes, **caractérisé en ce que** les connexions de source du miroir de courant (6) à canal p sont reliées à une première ligne d'alimentation (VDD).

5. Régulateur de tension selon l'une quelconque des revendications précédentes, **caractérisé en ce qu'**une deuxième sortie (13) du miroir de courant (6) à canal p est couplée à une entrée (14) d'un premier miroir de courant (15) à canal n, dont la sortie (16) est couplée avec le deuxième point fixe (k2).

6. Régulateur de tension selon l'une quelconque des revendications précédentes, **caractérisé en ce que** les connexions de source du premier miroir de courant (15) à canal n et la connexion de drain du premier transistor (4) à canal p sont branchées à une deuxième ligne d'alimentation qui est négative par rapport à la première ligne d'alimentation (VDD).

7. Régulateur de tension selon l'une quelconque des revendications précédentes, **caractérisé en ce que**, entre la ligne de sortie (a) et la deuxième ligne d'alimentation, un deuxième transistor (17) à canal p, un deuxième transistor (18) à canal n et une source de courant (19) sont branchés en série, une connexion de la source de courant (19) étant reliée avec la deuxième ligne d'alimentation et la deuxième connexion de la source de courant (19) est reliée au deuxième point fixe (k2).

8. Régulateur de tension selon l'une quelconque des revendications précédentes, **caractérisé en ce qu'**un premier condensateur (21) est branché en parallèle sur les deuxièmes transistors (17, 18).

9. Régulateur de tension selon l'une quelconque des revendications précédentes, **caractérisé en ce qu'**un deuxième condensateur (22) est branché entre la ligne de sortie et un potentiel fixe, en particulier le potentiel de masse.

10. Régulateur de tension selon l'une quelconque des revendications précédentes, **caractérisé en ce qu'**un troisième condensateur (23) est branché entre la sortie (3) de l'amplificateur de régulation (2) et la deuxième ligne d'alimentation.

11. Régulateur de tension selon l'une quelconque des revendications précédentes, **caractérisé par** un circuit de détection qui reconnaît un domaine de basses tensions de première ligne d'alimentation (VDD) et modifie, dans le domaine de basses tensions, le signal de sortie du l'amplificateur de régulation (2) en une direction prédéterminée.

12. Régulateur de tension selon l'une quelconque des revendications précédentes, **caractérisé en ce que** le circuit de détection comprend un troisième transistor (24) à canal p dont la connexion de porte est branchée en commun avec les connexions de porte du miroir de courant (6) à canal p, dont la connexion de source est couplée à la première entrée (11) du miroir de courant (6) à canal p et dont la connexion de drain est couplée à la sortie (3) du l'amplificateur de régulation (2).

13. Régulateur de tension selon l'une quelconque des revendications précédentes, **caractérisé en ce que** le circuit de détection comprend un deuxième miroir de courant (26) à canal n dont l'entrée (25) est couplée avec la connexion de drain du troisième transistor (24) à canal p et dont la sortie (27) est couplée avec la sortie (3) de l'amplificateur de régulation (2).

14. Régulateur de tension selon l'une quelconque des revendications précédentes, **caractérisé en ce que** les connexions de source du deuxième miroir de courant (26) à canal n sont reliées à la deuxième ligne d'alimentation.

15. Régulateur de tension selon l'une quelconque des revendications précédentes, **caractérisé en ce que**, dans au moins une branche de courant transversal, on prévoit au moins un étage cascode.
